# EUROPÄISCHE PATENTSCHRIFT

(11) **EP 0 755 072 B1**
(45) Veröffentlichungstag und Bekanntmachung des Hinweises auf die Patenterteilung: **06.03.2002**
(21) Anmeldenummer: 96111246.3
(22) Anmeldetag: 11.07.1996
(51) Int. Cl.: H01L 21/765, H01L 27/092

(54) **Verfahren zur Herstellung von isolierten, aktiven Bereichen einer CMOS-Schaltung**
Method of production isolated active regions in a CMOS circuit
Procédé de fabrication de regions actives isolées dans un circuit CMOS

(30) Priorität: 20.07.1995 DE 19526568
(43) Veröffentlichungstag der Anmeldung: 22.01.1997
(73) Patentinhaber: Infineon Technologies AG, 81669 München (DE)
(72) Erfinder: Kerber, Martin, Dr. rer. nat., 81827 München (DE)
(74) Vertreter: Zedlitz, Peter, Dipl.-Inf.

(56) Entgegenhaltungen:
- DE-A- 3 932 445
- DE-A- 3 942 419
- US-A- 4 825 278
- PATENT ABSTRACTS OF JAPAN vol. 18, no. 311 (E-1561), 14.Juni 1994 & JP-A-06 069510 (RICOH CO LTD), 11.März 1994,
- PATENT ABSTRACTS OF JAPAN vol. 12, no. 287 (E-643), 5.August 1988 & JP-A-63 064365 (HITACHI LTD), 22.März 1988,

## Beschreibung

Die Erfindung betrifft ein Verfahren zur Herstellung von isolierten, aktiven Bereichen einer CMOS-Schaltung.

Die DE 39 42 419 A1 offenbart eine Halbleitervorrichtung und ein entsprechendes Herstellungsverfahren, wobei auf einem Halbleitersubstrat eine Oxidschicht erzeugt wird und auf die Oxidschicht eine durchgehende Feldplattenschicht aufgebracht wird, die die aktiven Bereiche überlappt. Die durchgehende Feldplattenschicht wird mit zwei elektrischen Kontakten versehen, wobei ein Kontakt an einem ersten Bereich der Feldplattenschicht angeschlossen und der andere Kontakt an einem komplementären Bereich der Feldplatte angeschlossen wird.

Beim Aufbau von CMOS-Schaltkreisen auf einer Halbleiterfläche müssen die aktiven Bauelemente, also die beiden komplementären Transistoren, gegeneinander isoliert werden.

Üblicherweise werden die aktiven Bereiche integrierter CMOS-Schaltkreise durch lokale Oxidation von Silizium isoliert. Hierbei spricht man auch von der LOCOS-Technik. Dabei wird eine strukturierte Nitridschicht als Oxidationsbarriere verwendet und außerhalb der abgedeckten Bereiche auf der Siliziumoberfläche durch feuchte Oxidation ein Gateoxid von etwa 600 bis 1.000 nm erzeugt. Ein anderes übliches Verfahren ist die Ätzung eines flachen Grabens und die anschließende Füllung dieses Grabens mit einem Oxid (shallow trench isolation STI).

Bekannt ist außerdem die Verwendung von Feldplatten aus dotierten Polysilizium das durch eine Oxidschicht abgedeckt ist. Die Feldplatte dient zur Abschirmung des aktiven Bereichs und ist daher an das entsprechende Potential der darunter liegenden Wanne gekoppelt. An den Übergangsbereichen zwischen komplementären Wannen muß die Feldplatte deshalb unterbrochen sein.

Der Erfindung liegt die Aufgabe zugrunde, ein Verfahren zur Herstellung von isolierten aktiven Bereichen einer CMOS-Schaltung mit besonders geringem Platzbedarf zu Schaffen.

Die Lösung dieser Aufgabe erfolgt mit den kennzeichnenden Merkmalen des Anspruchs 1. Vorteilhafte Weiterbildungen sind in den Unteransprüchen beschrieben.

Die Feldplattenbereiche der komplementären aktiven Bereiche werden mit dem gleichen Leitungstyp und nicht wesentlich größerer Dotierstoffkonzentration wie die darunter liegende Wanne dotiert, und die Feldplattenbereiche sind im Grenzbereich der komplementären aktiven Bereiche miteinander verbunden, wobei in diesem Grenzbereich eine Sperrschicht vorhanden ist. Die Feldplatte ist also durchgehend ausgebildet und überlappt die komplementären Wannen.

Dadurch kann der Abstand von zwei in komplementären Wannen befindlichen aktiven Bereiche minimiert werden. Gleichzeitig erhält man einen kleinen Isolationspitch.

Bevorzugt beträgt die Dotierstoffkonzentration in den Wannen und dem darüber liegenden Feldplattenbereich 10¹⁷ bis 10¹⁸ cm⁻³. Durch die niedrige Dotierstoffkonzentration bildet sich bei Betriebsspannung an den Wannenkanten eine Sperrschicht mit ausreichender Spannungsfestigkeit. Das gleiche gilt für die durchgehende Feldplatte, deren verschiedene Bereiche entsprechend der darunter liegenden Wanne dotiert sind, so daß sie nicht galvanisch getrennt werden müssen. Zwischen diesen Bereichen bildet sich ebenfalls eine ladungsträgerfreie Sperrschicht aus.

Die Feldplatte wird bevorzugt mit der darunter liegenden Wanne elektrisch verbunden. Da außerdem der Ladungsträgertyp des Feldplatten-Polysiliziums dem der darunter liegenden Wanne entspricht, herrschen an der Halbleiteroberfläche immer nahezu Flachbandbedingungen, was eine sichere Isolation zwischen benachbarten aktiven Bereichen garantiert, mindestens dann, wenn die Isolationslänge nicht kürzer ist als die kleinste zugelassene Gatelänge der komplementären MOSFETs. Durch die gleichzeitige Implantierung in die Wanne und die entsprechende Feldplatte trifft dies für beide Transistortypen gleichermaßen zu. Die Kontaktierung der Feldplatten wird dabei bevorzugt durch überlappende oder versetzte Wannenkontakte vorgenommen. Infolge der geringen Dotierung der Feldplatten führt dies zu in Flußrichtung gepolten Schottkykontakten. Da in den pn-Übergängen der Feldplattenbereiche an den Wannenkanten nur kleine Sperrströme auftreten, ergeben sich an den Schottkykontakten auch nur unbedeutende Spannungsabfälle.

In einer Weiterentwicklung der Erfindung sind die Feldplattenbereiche nur in einem Teilbereich miteinander verbunden. Dies ist üblicherweise der Bereich, in dem die Gatepolysiliziumbahn verläuft und sonst Einfluß auf die darunter liegende Wanne nehmen würde. Durch diese Maßnahme kann der Leckstrom zwischen komplementären Feldplatten weiter reduziert werden.

Zur Herstellung von isolierten aktiven Bereichen einer CMOS-Schaltung wird erfindungsgemäß auf einem Halbleitersubstrat eine Oxidschicht erzeugt, auf die Oxidschicht eine durchgehende Feldplattenschicht, die die aktiven Bereiche überlappt, aufgebracht, mit einer Maskentechnik eine Wanne und dabei gleichzeitig der darüber liegende Feldplattenbereich durch Implantation dotiert, mit einer zweiten Maskentechnik die Dotierung einer komplementären Wanne gleichzeitig mit dem darüber liegenden Feldplattenbereich durchgeführt und die durchgehende Feldplattenschicht mit zwei elektrischen Kontakten versehen, wobei ein Kontakt im Bereich der ersten dotierten Wanne und der andere Kontakt im Bereich der zweiten dotierten Wanne angeschlossen wird.

Durch dieses Verfahren erhält man isolierte Feldplatten, die die gleiche Dotierung wie die darunter liegende Wanne aufweisen und durch eine elektrische Verbindung bevorzugt auf das gleiche Potential wie die darunter liegende Wanne gebracht werden. In diesem Fall herrschen an der Halbleiteroberfläche Flachbandbedingungen.

Die Strukturierung der Feldplattenschicht zur Erzeugung der Gateanschlüsse wird bevorzugt vor der Dotierung der Feldplattenbereiche und den jeweils darunter liegenden Wannen durchgeführt. Es ist jedoch alternativ auch möglich, zunächst die Dotierung der Feldplattenbereiche vorzunehmen und erst dann die Strukturierung der aktiven Bereiche vorzunehmen.

Weitere Vorteile dieses Verfahrens sind, daß die aus Polysilizium bestehenden Feldplatten und eine darüber liegende Feldoxidschicht mit geringem Aufwand herstellbar sind, daß der gesamte Herstellungsprozeß ohne CVD-Nitridabscheidung und nachfolgende Feuchtoxidation hergestellt werden kann, daß der Rand der aktiven Bereiche bei der Herstellung mechanisch nicht belastet wird und dadurch nur ein minimaler Diodenleckstrom entsteht.

In einer anderen Variante ist dieses Verfahren auch unverändert zur Herstellung einer CMOS-Schaltung auf SOI-Grundmaterial (Silizium auf einem Isolator) einsetzbar.

Nachfolgend wird die Erfindung anhand einer Zeichnung weiter erläutert. Im einzelnen zeigen die schematischen Darstellungen in:
- Figur 1: eine Draufsicht auf eine erfindungsgemäße CMOS-Schaltung, und
- Figur 2: einen Querschnitt durch die in Figur 1 gezeigte CMOS-Schaltung entlang der Gatestruktur.

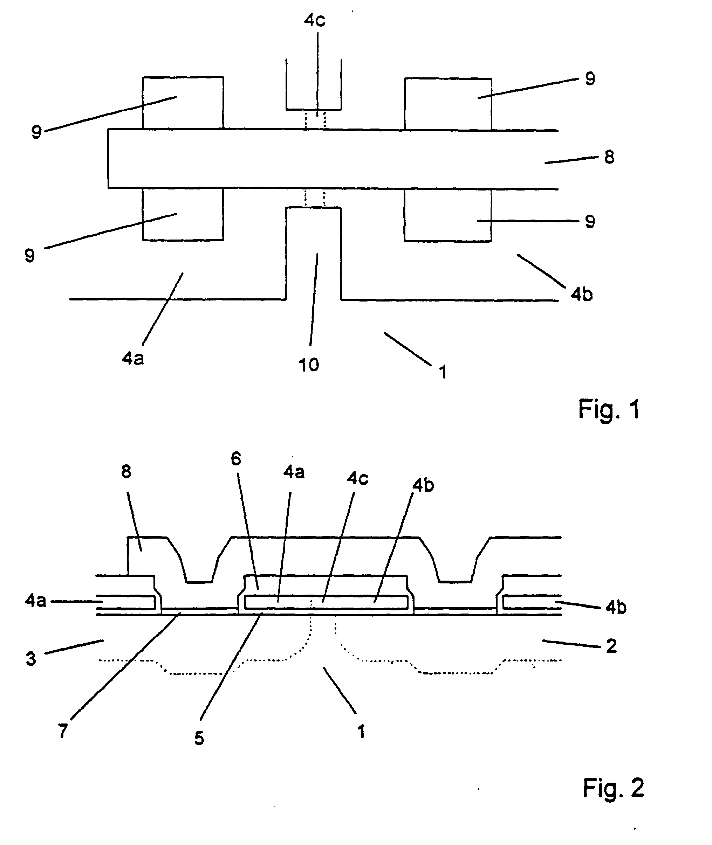

In Figur 1 ist die CMOS-Schaltung in Draufsicht dargestellt. Auf einem Halbleitersubstrat 1 sind dabei die darüber liegenden Feldplattenbereiche 4a und 4b dargestellt, die die aktiven Bereiche (typischerweise bestehend aus einem Sourcebereich, einem Kanalbereich und einem Drainbereich) umgeben, wobei die lateralen Abmessungen des Feldbereiches ein Minimalmaß nicht unterschreiten. Im Übergangsbereich zwischen den beiden Feldplattenbereichen 4a und 4b entsteht eine ladungsträgerfreie Sperrschicht 4c, in der in der die angelegte Spannung zuzüglich der eingebauten Diodenspannung im Übergangsbereich der komplementär dotierten Feldplattenbereiche abfällt. Die Feldplattenbereiche 4a und 4b weisen in ihrem Inneren Ausnehmungen 9 auf, in der die Gateelektrode 8 nach unten auf das Gateoxid 7 und die jeweilige darunter liegende Wanne geführt ist. Die Kontaktlänge der Feldplattenbereiche 4a und 4b ist auf einen Bereich unterhalb der Gatepolysiliziumbahn beschränkt, so daß zwischen den Feldplattenbereichen 4a und 4b ein Einschnitt 10 entsteht.

In Figur 2 ist ein Querschnitt durch die Figur 1 entlang des Gates 8 dargestellt. In dem Halbleitersubstrat 1 sind eine n-dotierte Wanne 2 und eine p-dotierte Wanne 3 durch Implantation erzeugt worden, über denen eine Oxidschicht 5 abgeschieden ist. Eine Feldplatte erstreckt sich über die gesamte CMOS-Schaltung. Die Feldplatte besteht aus einem Feldplattenbereich 4a, der ebenso wie die darunter liegende Wanne 3 p-dotiert ist und einem Feldplattenbereich 4b, der ebenso wie die darunter liegende Wanne 2 n-dotiert ist. Die Feldplatte besteht aus einer Polysiliziumschicht von ungefähr 70 nm Dicke und ist vom Substrat 1 bzw. den Wannen 2 und 3 durch eine ungefähr 10 nm dicke Oxidschicht 5 getrennt. Die Dicke dieser Oxidschicht 5 ist unkritisch, da bei an die Wannen angeschlossenen Feldplattenbereichen in dieser Schicht keine Spannung abfällt. Auch die Defektdichte und Spannungsfestigkeit dieses Oxids ist unkritisch. Die Feldplatte sollte ausreichend dick sein, so daß keine vollständige Verarmung auftreten kann. Dies kann mit einer Dicke von ungefähr 70 nm gewährleistet werden. Die Feldplatte ist nach oben von einem Feldoxid 6 mit einer Dicke von ungefähr 100 nm umgeben und damit ausreichend dick, um im Polysilizium der Feldplatte das Auftreten einer starken Inversion zu verhindern. Insgesamt bemüht man sich jedoch, die Dicke der Feldplatte 4 und der Feldoxidschicht 6 so klein wie möglich zu halten, um die Stufenhöhe zwischen den aktiven Transistorbereichen und dem Isolationsbereich zu minimieren. Das Gate 8 besteht aus einer Polysiliziumschicht mit einer Dicke von ungefähr 250 nm.

Zur Herstellung einer solchen Struktur wird dabei auf einer einkristallinen Siliziumscheibe, die in den Figuren als Halbleitersubstrat 1 dargestellt ist, eine dünne Oxidschicht 5 thermisch erzeugt. Darauf wird eine undotierte Siliziumschicht (die spätere Feldplattenschicht 4) geringer Dicke aus Polysilizium oder amorphem Silizium, welches im nächsten Hochtemperaturschritt rekristallisiert, und eine Oxidschicht 6 abgeschieden. Die Oxidschicht 6 wird vorzugsweise durch Abscheidung von TEOS erzeugt. Die Siliziumschicht 4 und die Oxidschicht 6 werden mit einer ersten Fototechnik anisotrop strukturiert. Dann wird mit einer zweiten Fototechnik die Implantierung für einen MOS-Transistortyp eingebracht. Es wird also beispielsweise die n-dotierte Wanne 2 und der darüber liegende n-dotierte Feldplattenbereich 4b erzeugt. Mit einer dritten Fototechnik werden dann die entsprechenden Masken für die Implantierung des komplementären Transistortyps erzeugt. Dabei wird dann die p-dotierte Wanne 3 und der darüber liegende p-dotierte Feldplattenbereich 4a erzeugt. In den Bereichen 9 und 10, die nicht von einem Feldplattenbereich abgedeckt sind, wird dann das dünne erste Oxid 5 isotrop entfernt und ein Gateoxid 7 erzeugt und darauf die Gatelektrode 8 abgeschieden und strukturiert.

Bei einem konventionellen LOCOS-Verfahren hätte im Bereich des Gateanschlusses die Halbleiteroberfläche mit einer etwa 200 nm dicken Schicht anstelle der hier verwendeten, ungefähr 10 nm dicken Oxidschicht 3 aufoxidiert werden müssen. Dem gegenüber ergibt sich im erfindungsgemäßen Verfahren eine verminderte Dotierstoffsegregation und engere Einsatzspannungs-Toleranzen.

## Patentansprüche

1. Verfahren zur Herstellung von isolierten aktiven Bereichen einer CMOS-Schaltung, bei dem
a) auf einem Halbleitersubstrat (1) eine Oxidschicht (5) erzeugt wird,
b) auf die Oxidschicht (5) eine durchgehende Feldplattenschicht, die die aktiven Bereiche überlappt, aufgebracht wird,
c) eine Wanne (2) im Halbleitersubstrat durch eine Dotierung des ersten Leitfähigkeitstyps gebildet wird und dabei gleichzeitig ein darüber liegender Feldplattenbereich (4b) dotiert wird,
d) eine komplementäre Wanne (3) im Halbleitersubstrat, neben der Wanne (2), durch eine Dotierung des zweiten Leitfähigkeitstyps gebildet wird und gleichzeitig ein darüber liegender komplementärer Feldplattenbereich (4a) dotiert wird, und
e) die durchgehende Feldplattenschicht mit zwei elektrischen Kontakten versehen wird, wobei ein Kontakt am in Schritt c) dotierten Feldplattenbereich (4b) und der andere Kontakt am in Schritt d) dotierten komplementären Feldplattenbereich (4a) angeschlossen wird.

2. Verfahren nach Anspruch 1,
**dadurch gekennzeichnet,**
**daß** die elektrischen Kontakte mit der jeweils darunter liegenden Wanne (2, 3) verbunden werden.

3. Verfahren nach einem der Ansprüche 1 oder 2,
**dadurch gekennzeichnet,**
**daß** das Verfahren auf einem SOI-Grundmaterial durchgeführt wird.

4. Verfahren nach einem der Ansprüche 1 bis 3,
**dadurch gekennzeichnet,**
**daß** eine Strukturierung der Feldplattenschicht zur Herstellung von Ausnehmungen zwischen den Schritten b) und c) durchgeführt wird.

5. Verfahren nach einem der vorhergehenden Ansprüche,
**dadurch gekennzeichnet,**
**daß** die Wannen (2, 3) retrograd dotiert werden.

## Claims

1. Method for fabricating insulated active regions of a CMOS circuit, in which
a) an oxide layer (5) is produced on a semiconductor substrate(1),
b) a continuous field plate layer which overlaps the active regions is applied to the oxide layer (5),
c) a well (2) is formed in the semiconductor substrate by a doping of the first conductivity type and a field plate region (4b) lying above the said well is simultaneously doped in the process,
d) a complementary well (3) is formed in the semiconductor substrate, beside the well (2), by a doping of the second conductivity type and a complementary field plate region (4a) lying above the said complementary well is doped at the same time, and
e) the continuous field plate layer is provided with two electrical contacts, one contact being connected to the field plate region (4b) doped in step c) and the other contact being connected to the complementary field plate region (4a) doped in step d).

2. Method according to Claim 1,
**characterized**
**in that** the electrical contacts are connected to the respective underlying well (2, 3).

3. Method according to either of Claims 1 and 2,
**characterized**
**in that** the method is carried out on an SOI basic material.

4. Method according to one of Claims 1 to 3,
**characterized**
**in that** patterning of the field plate layer in order to fabricate recesses is carried out between steps b) and c).

5. Method according to one of the preceding claims,
**characterized**
**in that** the wells (2, 3) are doped in a retrograde manner.

## Revendications

1. Procédé pour la fabrication de zones actives et isolées d'un circuit CMOS, par lequel
a) une couche d'oxyde (5) est générée sur un substrat semi-conducteur (1)
b) une couche continue de magnétorésistance, qui recouvre les zones actives, est appliquée sur la couche d'oxyde (5),
c) une cuve (2) dans le substrat semi-conducteur est formée par un dopage du premier type de conductibilité et une zone de magnétorésistance (4b) disposée dessus est dopée simultanément,
d) une cuve (3) complémentaire dans le substrat semi-conducteur est formée, parallèlement à la cuve (2), par un dopage du deuxième type de conductibilité et une zone de magnétorésistance (4a) complémentaire disposée dessus est dopée simultanément, et
e) la couche continue de magnétorésistance est pourvue de deux contacts électriques, un contact étant raccordé sur la zone de magnétorésistance (4b) dopée dans l'étape c) et l'autre contact étant raccordé sur la zone de magnétorésistance (4a) complémentaire et dopée dans l'étape d).

2. Procédé selon la revendication 1, **caractérisé en ce que** les contacts électriques sont reliés chacun à la cuve (2, 3) située au-dessous.

3. Procédé selon l'une quelconque des revendications 1 ou 2, **caractérisé en ce que** le procédé est appliqué sur un matériau de base de type SOI.

4. Procédé selon l'une quelconque des revendications 1 à 3, **caractérisé en ce qu'**une structuration de la couche de magnétorésistance est effectuée pour la fabrication d'évidements entre les étapes b) et c).

5. Procédé selon l'une quelconque des revendications précédentes, **caractérisé en ce que** les cuves (2, 3) sont dopées de façon rétrograde.
